# EUROPÄISCHE PATENTSCHRIFT

(11) **EP 2 929 395 B1**
(45) Veröffentlichungstag und Bekanntmachung des Hinweises auf die Patenterteilung: **20.03.2019**
(21) Anmeldenummer: 13811785.8
(22) Anmeldetag: 09.12.2013
(51) Int. Cl.: H01S 3/115, G02F 1/03, H03K 17/10

(54) **POCKELSZELLENTREIBERSCHALTUNG UND VERFAHREN ZUM BETRIEB EINER POCKELSZELLE**
POCKELS CELL DRIVER CIRCUIT AND METHOD FOR OPERATING A POCKELS CELL
CIRCUIT PILOTE DE CELLULE DE POCKELS ET PROCÉDÉ D'EXPLOITATION D'UNE CELLULE DE POCKELS

(30) Priorität: 10.12.2012 DE 102012222606
(43) Veröffentlichungstag der Anmeldung: 14.10.2015
(73) Patentinhaber: TRUMPF Laser GmbH, 78713 Schramberg (DE)
(72) Erfinder: EDLER, Hans Georg, 78733 Aichhalden (DE)
(74) Vertreter: Kohler Schmid Möbus Patentanwälte
(86) Internationale Anmeldenummer: PCT/EP2013/003712
(87) Internationale Veröffentlichungsnummer: WO 2014/090392

(56) Entgegenhaltungen:
- WO-A1-2011/009467
- DE-A1- 3 630 775
- DE-B3-102007 004 391
- JP-A- S56 140 686

## Beschreibung

Die Erfindung betrifft eine Pockelszellentreiberschaltung mit den Merkmalen des Oberbegriffs des Anspruchs 1.

Eine Pockelszelle besteht aus einem elektrooptischen Kristall, durch welche elektromagnetische Strahlung (z.B. Laserlicht mit λ= 0,2-2 µm) propagieren kann. Die Phasenverschiebung; die die elektromagnetische Strahlung im Kristall erfährt, kann durch Anlegen einer variierenden elektrischen Spannung verändert werden (Pockelseffekt). Die Pockelszelle wirkt als spannungsabhängige Wellenplatte. Pockelszellen werden zusammen mit weiteren optischen Komponenten wie Polarisatoren in elektrooptischen Modulatoren verwendet und können damit als Aus- und Einkoppler für elektromagnetische Strahlung in Lasern eingesetzt werden. Um den Modulator in einen Sperr- oder Offen-Zustand zu versetzen wird eine veränderliche Spannung an die Pockelszelle angelegt. Somit können sie in Lasern z.B. zum Erzeugen von Pulsen in regenerativen Verstärkern oder Lasern nach dem "Cavity dump" Prinzip eingesetzt werden. Die Spannung wird mittels einer Pockelszellentreiberschaltung gesteuert. Beim Einsatz des Lasers in der Materialbearbeitung muss der Laser meist ultrakurze Pulse mit hoher Energie liefern. Bei z.B. einem regenerativen Verstärkersystem wird der Laserstrahl hierzu über die Pockelszelle in den optischen Verstärker eingekoppelt durchläuft diesen so oft, bis die benötigte Energie erreicht wird und wird dann wieder ausgekoppelt. Hierzu muss der Schaltprozess innerhalb einer Umlaufzeit im Resonator des regenerativen Verstärkers erfolgen. Es gilt je kürzer die Schaltdauer (steile Schaltflanke), desto mehr Schaltzyklen können innerhalb einer vorgegebenen Verstärkungsdauer erreicht werden (hohe Taktrate). Die Ansteuerung von Pockelszellen erweist sich jedoch häufig als schwierig. Vor allem bei hohen Laserleistungen werden hohe Spannungen erforderlich, die in kurzer Zeit angelegt oder abgeschaltet werden muss. Aus dem Stand der Technik sind Pockelszellentreiber beispielsweise gemäß der US3910679 bekannt. Die dort gezeigte Anordnung wird als H-Konfiguration und die Betriebsweise als Push-Pull-Schaltung bezeichnet. Diese Konfiguration hat den Nachteil, dass bei hohen Laserleistungen und schnellen Schaltzeiten die thermische Belastung auf den Bauteilen sehr hoch wird, da viele Komponenten verwendet und angesteuert werden müssen und die extrem schnellen Schaltzeiten können nicht mehr erreicht werden. Des Weiteren wird das Gesamtsystem aufgrund der thermischen Belastung immer anfälliger für Ausfälle.

Aus der WO 2011 / 009467 A1 und der DE 10 2007 00 4391 B3 sind Pockelszellentreiberschaltungen bekannt, in denen zur Ansteuerung einer Pockelszelle jeweils mehrere Schalter vorgesehen sind, die direkt mit einer Pockelszelle verbunden sind. Je nach Stellung der Schalter kann die Pockelszelle geladen oder entladen werden. Jedoch müssen für einen ordnungsgemäßen Betrieb jeweils mehrere Schalter synchron geschaltet werden. Dabei sind jeweils gleichzeitig bestimmte Schalter zu öffnen und andere Schalter zu schließen.

Eine Möglichkeit, die für diese Anordnungen benötigten Schalter zu realisieren, wird in der DE 36 30 775 A1 beschrieben. Um zur Schaltung hoher Spannungspotenziale die Durchbruchspannung eines Schalters zu erhöhen, ist insbesondere vorgeschlagen, den Schalter als Reihenschaltung mehrerer Einzelschalter vorzusehen.

Jedoch bleibt offen, wie ein gleichzeitiges Schalten der Schalter einer Pockelszellentreiberschaltung, insbesondere mit mehreren Einzelschaltern, in der jeweils erforderlichen Weise beziehungsweise Schaltrichtung sichergestellt werden kann.

Zwar ist aus der JP S56 140686 A eine Pockelszellentreiberschaltung bekannt, in der mehrere Schalter gleichzeitig geschaltet werden, jedoch wird die Pockelszelle nach einem grundsätzlich andersartigen Prinzip über RC-Glieder angesteuert. Hiermit sind mehrere Nachteile verbunden, beispielsweise ergeben sich in dieser Anordnung hohe Verlustleistungen aufgrund im Hochspannungsteil befindlicher, parallel zur Pockelszelle geschalteter Widerstandsketten. Auch kann die gleichzeitige Ansteuerung der Schalter nicht auf die zuvor beschriebenen Anordnungen übertragen werden, da alle Schalter jeweils nur mit jeweils gleicher Schaltrichtung geschaltet werden können.

Aufgabe der vorliegenden Erfindung ist es daher, eine Pockelszellentreiberschaltung derart weiterzuentwickeln, dass gewährleistet ist, dass zur Ansteuerung einer Pockelszelle vorgesehene Schalter jeweils mit ihren in Reihe geschalteten Einzelschaltern in geeigneter Weise beziehungsweise Schaltrichtung synchron, insbesondere gleichzeitig, geschaltet werden können.

Gelöst wird diese Aufgabe erfindungsgemäß durch eine Pockelszellentreiberschaltung mit den Merkmalen des Anspruchs 1.

Bei dieser Pockelszellentreiberschaltung haben die Pockelszellenanschlüsse, d.h. die Schaltungsknoten, ein symmetrisch verteiltes positives und negatives Potential gegenüber Masse. Eine Ansteuerschaltung für die Pockelszellentreiberschaltung kann somit ebenfalls auf Masse liegen. Die Ansteuerschaltung kann mit den Schaltern verbunden sein. Mit der erfindungsgemäßen Pockelszellentreiberschaltung kann eine Pockelszelle sehr schnell geschaltet werden. Außerdem können hohe Spannungen geschaltet werden. Die Pockelszellentreiberschaltung kann mit wenigen Komponenten realisiert werden, so dass die Ausfallwahrscheinlichkeit reduziert ist.

Der Kurzschlussschalter kann so ausgelegt sein, dass eine Spannung zwischen den Schaltungsknoten von > 1000V, insbesondere > 2kV, vorzugsweise > 4kV, besonders vorzugsweise auch >8kV auf < 100V in einer Zeitspanne < 200ns, insbesondere < 100ns, vorzugsweise < 50ns, besonders bevorzugt <10ns reduziert werden kann.

Weiterhin kann der Kurzschlussschalter so ausgelegt sein, dass eine Pockelszelle mit einer Kapazität zwischen 1pF und 20pF, die auf eine Spannung > 1000V, insbesondere > 2kV, vorzugsweise > 4kV, besonders vorzugsweise auch >8kV in einer Zeitspanne < 200ns, insbesondere < 100ns, vorzugsweise < 50ns, besonders bevorzugt <10ns auf Spannung < 100V entladen werden kann. Dafür sind spezielle sehr schnell schaltende Transistoren notwendig. Derzeit vorteilhaft haben sich n-Kanal-MOS-FET herausgestellt. Jedoch werden hier stetig neue Technologien entwickelt, so dass die Erfindung nicht auf MOS-FETs beschränkt sein soll.

Weiterhin kann der Kurzschlussschalter so ausgelegt sein, dass beim Einschalten eine Ladung >100nC, insbesondere >200nC, vorzugsweise >400nC, besonders vorzugsweise auch >800nC innerhalb einer Zeitspanne < 100ns, insbesondere < 10ns aus der Pockelszelle entladen werden kann.

Um die hohen Spannungen schalten zu können, ist es vorteilhaft, wenn der Kurzschlussschalter eine Reihenschaltung mehrerer Einzelschalter umfasst. Die Einzelschalter können dabei elektronisch ansteuerbare Halbleiterelemente sein, insbesondere MOSFETs.

Weiterhin können der erste und zweite Schalter jeweils eine Reihenschaltung mehrerer Einzelschalter umfassen. Auch dies ist vorteilhaft, um hohe Spannungen schalten zu können.

Dabei können der erste und der zweite Schalter jeweils eine gleiche Anzahl von Einzelschaltern umfassen. Die Reihenschaltung der Einzelschalter des Kurzschlussschalters kann mehr, insbesondere doppelt so viele Einzelschalter umfassen als die Reihenschaltung der Einzelschalter des ersten Schalters. Umgekehrt gesehen können also der erste und der zweite Schalter weniger, insbesondere halb so viele Einzelschalter aufweisen wie der Kurzschlussschalter. Das spart Bauteile und erhöht die Sicherheit.

Die Reihenschaltung der Einzelschalter des Kurzschlussschalters bildet mit der Reihenschaltung der Einzelschalter des ersten und des zweiten Schalters eine Reihenschaltung aller Einzelschalter. In dieser Reihenschaltung können ein oder mehrere Widerstände angeordnet sein. Damit lassen sich unerwünschte Schwingungen bedämpfen. Insbesondere können je ein Widerstand zwischen dem ersten Schaltungsknoten und dem positiven Potential und zwischen dem zweiten Schaltungsknoten und dem negativen Potential angeordnet sein. Insbesondere können je ein Widerstand unmittelbar am Anschluss des positiven Potentials und des negativen Potentials angeordnet sein. Das ergibt eine besonders wirkungsvolle Bedämpfung der Schwingungen und erhält die symmetrische Struktur, was wiederum die synchrone Ansteuerung verbessert. Die Widerstände können Werte zwischen 1 und 200 Ohm haben.

An den Schaltungsknoten kann eine Pockelszelle angeschlossen werden. Insbesondere können je ein Widerstand zwischen dem ersten Schaltungsknoten und einem ersten Pockelszellenanschluss, sowie dem zweiten Schaltungsknoten und einem zweiten Pockelszellenanschluss angeordnet sein. Auch diese Widerstände helfen unerwünschte Schwingungen zu bedämpfen. Die Widerstände können Werte zwischen 0,1 und 20 Ohm haben.

Jeder Einzelschalter kann eine Einschaltansteuerschaltung aufweisen, die ausgelegt ist, den Einzelschalter in einen leitenden Zustand zu versetzen. Insbesondere kann jedem Einzelschalter eine entsprechende Einschaltansteuerschaltung zugeordnet sein. Jeder Einzelschalter kann so individuell für sein Einschaltverhalten abgeglichen werden und die Schaltzeiten der Einzelschalter aufeinander synchronisiert werden.

Weiterhin kann jeder Einzelschalter eine Ausschaltansteuerschaltung aufweisen, die ausgelegt ist, den Einzelschalter in einen nicht leitenden Zustand zu versetzen. Insbesondere kann jedem Einzelschalter eine entsprechende Ausschaltansteuerschaltung zugeordnet sein. Jeder Einzelschalter kann so individuell für sein Ausschaltverhalten abgeglichen werden und die Schaltzeiten der Einzelschalter aufeinander synchronisiert werden. Insbesondere können mit einer Anordnung die je eine separate Ausschaltansteuerschaltung und Einschaltansteuerschaltung aufweisen, Einschaltzeiten und Ausschaltzeiten unabhängig voneinander abgeglichen werden. Damit können die Schalter verlustarm geschaltet werden.

Sowohl die Einschaltansteuerschaltung als auch die Ausschaltansteuerschaltung kann je einen ersten und zweiten Eingangsanschluss und je einen ersten und zweiten Ausgangsanschluss aufweisen. Dadurch ist es möglich, die Einzelschalter mittels Signalübertragern anzusteuern. Es ist daher vorteilhaft, wenn die Einschaltansteuerschaltungen bzw. die Ausschaltansteuerschaltungen je einen, insbesondere je einen baugleichen Signalübertrager aufweisen.

Die Signalübertrager können Primärseitenanschlüsse aufweisen, die jeweils mit einem Eingangsanschluss verbunden sind.

Die Signalübertrager können mit je einem ersten Anschluss einer Sekundärseite mit einem Leistungsanschluss des zugeordneten Einzelschalters, insbesondere direkt, verbunden sein. Durch die Signalübertrager kann eine Potentialtrennung realisiert werden, die Verwendung von Signalübertragern hat weiterhin den Vorteil, dass eine symmetrische und absolut gleichzeitige Ansteuerung der Einzelschalter möglich ist.

Die Signalübertrager können mit je einem zweiten Anschluss der Sekundärseite mit einem Ansteueranschluss des zugeordneten Einzelschalters verbunden sein.

Die Signalübertrager können mit je einem zweiten Anschluss der Sekundärseite über eine Zwischenschaltung, insbesondere aufweisend ein Bauelement mit nicht linearer Strom- Spannungskennlinie, vorzugsweise aufweisend eine Diode oder eine Reihenschaltung einer Diode mit einer Zenerdiode, mit einem Ansteueranschluss des zugeordneten Einzelschalters verbunden sein. So wird die Ladung dem Steueranschluss vorteilhaft zugeführt und hält die Schalter, insbesondere Transistoren, ausreichend lange eingeschaltet. Bei einer Reihenschaltung aus Diode und Zenerdiode können Diode und Zenerdiode gegensinnig miteinander verbunden sein. So kann die Spannung an dem Steueranschluss eingestellt werden und die Schaltgeschwindigkeit erhöht werden. Die Zenerdiode geht in den leitenden Betrieb, wenn die Spannungsänderung am Ausgang des Übertragers sehr hoch ist. Es kann so sehr sicher geschaltet werden und Schwingungen können vermieden werden.

Die Einschaltansteuerschaltungen des ersten und zweiten Schalters und die Ausschaltansteuerschaltung des Kurzschlussschalters können an ihren Eingangsanschlüssen in einer ersten Serienschaltung geschaltet sein. Dadurch kann sichergestellt werden, dass, immer wenn die ersten und zweiten Schalter einschalten, der Kurzschlussschalter aktiv gesperrt wird. Durch die Serienschaltung kann ein synchronisiertes, insbesondere gleichzeitiges, Schalten erzielt werden.

Die Ausschaltansteuerschaltungen des ersten und zweiten Schalters und die Einschaltansteuerschaltung des Kurzschlussschalters können an ihren Eingangsanschlüssen in einer zweiten Serienschaltung geschaltet sein. Dadurch kann sichergestellt werden, dass der erste und zweite Schalter synchronisiert, insbesondere gleichzeitig, mit dem Einschalten des Kurzschlussschalters-ausgeschaltet werden.

Die Serienschaltung der Ausschaltansteuerschaltungen des ersten und des zweiten Schalters und die Einschaltansteuerschaltung des Kurzschlussschalters können über einen ersten Treiberschalter an eine Treiberspannung anschließbar sein. Die Treiberspannung kann etwa 350V betragen, insbesondere kann sie im Bereich 100 bis 500V liegen.

Die Serienschaltung der Einschaltansteuerschaltungen des ersten und zweiten Schalters und die Ausschaltansteuerschaltungen des Kurzschlussschalters können über einen zweiten Treiberschalter an eine gesonderte oder an die gleiche Treiberspannung anschließbar sein.

Die Schaltungsknoten können bei geschlossenem ersten und zweiten Schalter betragsmäßig auf demselben Potential liegen. Damit ist gemeint , dass sie im Wesentlichen auf dem gleichem Absolutbetrag des Potentials bei unterschiedlicher Polarität liegen. Dadurch haben die Pockelszellenanschlüsse ein symmetrisch verteiltes positives und negatives Potential gegenüber Masse (Massepotential).

Eine oder mehrere, insbesondere alle Einschaltansteuerschaltungen und eine oder mehrere insbesondere alle Ausschaltansteuerschaltungen für die Pockelszellentreiberschaltung können auf einem Potential liegen, das weniger als 50 V Potentialabstand zu der Masse aufweist oder mit Masse verbunden ist.

Das Massepotential kann insbesondere mit einer Gehäusemasse verbunden sein bzw. auf demselben oder zumindest nahe bei dem Potential des Massegehäuses liegen. Mit "nahe" ist gemeint, dass die Potentialdifferenz zwischen Gehäusemasse und Mittenpotential kleiner ist als 100 mal der Betrag des ersten oder zweiten Potentials.

Es können Widerstände, insbesondere zwei Widerstände, insbesondere in Serie geschaltet, zwischen den Leistungsanschlüssen eines Einzelschalters vorgesehen sein. Dies bedeutet, dass die Leistungsanschlüsse eines Einzelschalters über Widerstände miteinander verbunden sein können. Diese Widerstände wirken symmetrierend. Insbesondere bei nicht leitend geschalteten Schaltern kann so sichergestellt werden, dass der Spannungsabfall an den einzelnen Einzelschalter sich möglichst gleichmäßig auf die Einzelschalter aufteilt und nicht ein Einzelschalter die ganze Spannung sperren muss. Außerdem kann dadurch ein gleichzeitiges Ein- und Ausschalten der Einzelschalter sichergestellt werden. Durch die Widerstände können die Gate-Kapazitäten entladen werden. Vorzugsweise weisen die Widerstände einen Widerstandswert > 100 kOhm auf.

Es können kapazitive Elemente, insbesondere Kondensatoren, zwischen den Leistungsanschlüssen eines Einzelschalters vorgesehen sein. Das bedeutet, dass die Leistungsanschlüsse eines Einzelschalters über kapazitive Elemente, insbesondere mindestens zwei kapazitive Elemente, insbesondere in Serie geschaltete kapazitive Elemente, miteinander verbunden sein können. Auch die kapazitiven Elemente sorgen für eine Symmetrierung. Insbesondere sorgen sie dafür, ungleiche Kapazitäten der Einzelschalter auszugleichen, die aufgrund des Spannungsabstands der Einzelschalter zur Bezugsmasse entstehen. Bei Einzelschaltern, die von der Pockelszelle aus gesehen das am weitest entfernte Potential aufweisen, können diese Kapazitäten am kleinsten ausfallen. Insbesondere können sie sogar entfallen, d.h. gar nicht vorhanden sein. Die Kapazitätswerte der kapazitiven Elemente liegen vorzugsweise im Bereich zwischen 4pF und 100pF. Die Werte der Widerstände liegen vorzugsweise zwischen 100kOhm und 100MOhm, insbesondere zwischen 400kOhm und 40MOhm. Durch die kapazitiven Elemente können auch Schwingungen vermieden werden.

Weiterhin können Widerstände in der ersten und insbesondere auch in der zweiten Serienschaltung vorgesehen sein. Insbesondere können baugleiche Widerstände mit gleichgroßen Werten, insbesondere im Bereich zwischen 1 Ohm und 50 Ohm, insbesondere zwischen 10 Ohm und 50 Ohm, verwendet werden. Diese Widerstände dienen zur Dämpfung von möglichen Schwingungen. Solche Schwingungen können auftreten, wenn Schalter sehr schnell geschaltet werden. Solche Schwingungen können einzelne Einzelschalter im Ausschaltvorgang wieder einschalten, was unerwünscht wäre, weil dann die Spannung des positiven bzw. negativen Potenzials die verbleibenden ausgeschalteten Einzelschalter über ihre Durchbruchspannung belasten könnte.

Einzelschalter können als Transistoren ausgebildet und auf einem Substrat angeordnet sein und die Leistungsanschlüsse können mit Bonddrähten verbunden sein.

Zur Ansteuerung zumindest des ersten oder zweiten Schalters kann ein Planartransformator vorgesehen sein. Insbesondere kann zur Ansteuerung jedes Einzelschalters des ersten oder zweiten Schalters ein eigener Planartransformator vorgesehen sein. Planartransformatoren können eine gute Kühlanbindung haben und daher gut gekühlt werden.

Die Pockelszellentreiberschaltung kann auf einem Substrat angeordnet sein und das Substrat kann auf einem Keramikkühlkörper angeordnet sein. Eine Kühlung ist vorteilhaft, da eine Temperaturänderung Auswirkung auf die Schaltflanke der Pockelszelle haben kann. Der Keramikkühlkörper kann als planarer Keramikkühlkörper mit Vertiefungen ausgebildet sein, sodass alle relevanten Bauteile, wie die Leiterplatte bzw. ein Substrat, Planartransformatoren und alle (Einzel-)Schalter eine optimale Kühlanbindung haben.

In den Rahmen der Erfindung fällt außerdem ein Verfahren zum Betrieb einer Pockelszelle mit einer erfindungsgemäßen Pockelszellentreiberschaltung, wobei zum Entladen der Pockelszelle der erste und zweite Schalter geöffnet und der Kurzschlussschalter geschlossen werden und zum Laden der Pockelszelle der erste und zweite Schalter geschlossen und der Kurzschlussschalter geöffnet werden. Dadurch lassen sich sehr steile Schaltflanken erzeugen. Außerdem können hohe Spannungen geschaltet werden.

Vorteile ergeben sich, wenn der Kurzschlussschalter nur geschlossen wird, wenn der erste und zweite Schalter geöffnet sind. So können Verluste, Strom- und Spannungsspitzen vermieden werden, die sowohl die Schalter als auch die Pockelszelle schädigen würden.

Es werden Schaltzustände vermieden, in denen der erste und zweite Schalter und der Kurzschlussschalter gleichzeitig geschlossen sind.

Die Einzelschalter des ersten und zweiten Schalters können jeweils durch jeweils eine eigene Einschaltansteuerschaltung und jeweils eine eigene Ausschaltansteuerschaltung angesteuert werden. Das erhöht die Zuverlässigkeit und die Schaltgeschwindigkeit. Außerdem können die Einzelschalter so besser synchronisiert werden.

Die Einzelschalter des Kurzschlussschalters können ebenfalls jeweils durch solch eine eigene Einschaltansteuerschaltung und eine eigene Ausschaltansteuerschaltung angesteuert werden.

Ein gleichzeitiges Schalten kann bewirkt werden, wenn ein erster Treiberschalter geschlossen wird, um den ersten und zweiten Schalter zu öffnen und den Kurzschlussschalter synchronisiert zu schließen.

Weiterhin kann ein zweiter Treiberschalter geschlossen werden, um den ersten und zweiten Schalter zu schließen und den Kurzschlussschalter synchronisiert zu öffnen.

Die Spannung über den Leistungsanschlüssen von Einzelschaltern des ersten und zweiten Schalters und/oder des Kurzschlussschalters können symmetriert werden.

Weitere Merkmale und Vorteile der Erfindung ergeben sich aus der nachfolgenden Beschreibung eines Ausführungsbeispiels der Erfindung, anhand der Figuren der Zeichnung, die erfindungswesentliche Einzelheiten zeigen, und aus den Ansprüchen. Die einzelnen Merkmale können je einzeln für sich oder zu mehreren in beliebiger Kombination bei einer Variante der Erfindung verwirklicht sein.

Ein bevorzugtes Ausführungsbeispiel der Erfindung ist in der Zeichnung schematisch dargestellt und wird nachfolgend mit Bezug zu den Figuren der Zeichnung näher erläutert. Es zeigen:
- Fig. 1: eine stark schematisierte Darstellung einer Pockelszelle mit einer Pockelszellentreiberschaltung;
- Fig. 2: eine Darstellung einer Pockelszelle mit einer Pockelszellentreiberschaltung, wobei im Vergleich zur Figur 1 zusätzlich Einzelschalter bezeichnet sind.
- Fig. 3: eine Pockelszelle mit einer Pockelszellentreiberschaltung, wobei zusätzlich Ansteuerschaltungen gezeigt sind;
- Fig. 4: eine Pockelszelle mit einer Pockelszellentreiberschaltung, wobei die Verschaltung der Ansteuerschaltungen dargestellt ist;
- Fig. 5: eine Pockelszelle mit einer Pockelszellentreiberschaltung;
- Fig. 6: Zeitdiagramme zur Darstellung des Ein- und Ausschaltens der Pockelszelle.

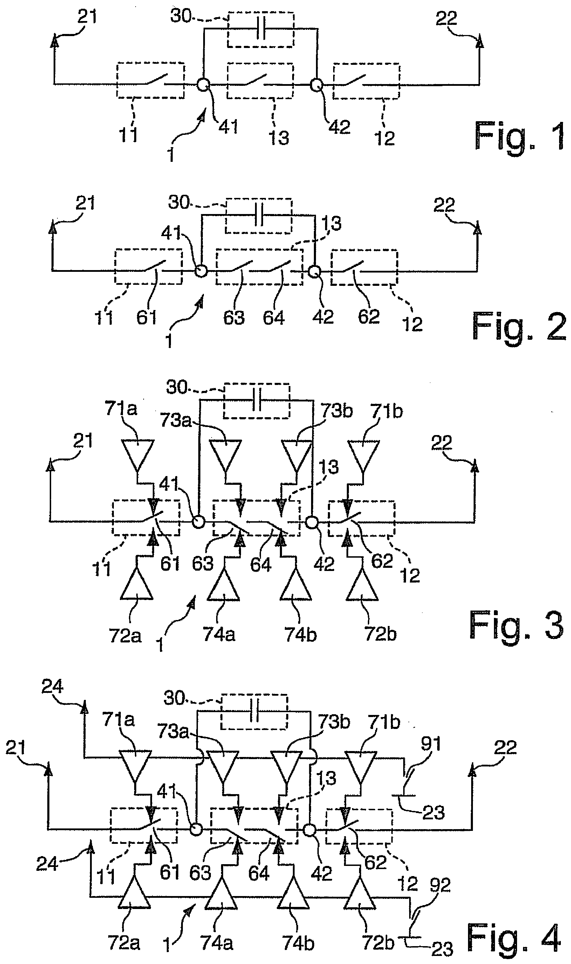

Die Figur 1 zeigt eine Pockelszellentreiberschaltung 1, an die eine Pockelszelle 30 angeschlossen ist. Insbesondere ist die Pockelszelle 30 an einem ersten Schaltungsknoten 41 und einem zweiten Schaltungsknoten 42 der Pockelszellentreiberschaltung 1 angeschlossen. Der erste Schaltungsknoten 41 ist über einen ersten Schalter 11 mit einem positiven Potential 21 verbunden. Der zweite Schaltungsknoten 42 ist über einen zweiten Schalter 12 an ein negatives Potential 22 angeschlossen. Die Schaltungsknoten 41, 42 sind über einen Kurzschlussschalter 13 miteinander verbunden.

In der in der Figur 2 gezeigten Ausführungsform ist weiterhin dargestellt, dass der erste Schalter 11 eine Reihenschaltung von mehreren Einzelschaltern 61 aufweist, wobei in der Figur 2 lediglich ein Einzelschalter 61 dargestellt ist. Der zweite Schalter 12 weist ebenfalls eine Reihenschaltung mehrerer Einzelschalter 62 auf, wobei nur ein Einzelschalter 62 dargestellt ist. Der Kurzschlussschalter 13 weist eine Reihenschaltung mehrerer Einzelschalter 63, 64 auf.

Wie sich der Figur 3 entnehmen lässt, ist den Einzelschaltern 61, 62 der ersten und zweiten Schalter 11, 12 jeweils eine Einschaltansteuerschaltung 71a, 71b zugeordnet, die dazu ausgelegt sind, die Einzelschalter 61, 62 in einen leitenden Zustand zu versetzen.

Weiterhin sind den Einzelschaltern 61, 62 Ausschaltansteuerschaltungen 72a, 72b zugeordnet, die dazu ausgelegt sind, die Einzelschalter 61, 62 in einen nicht leitenden Zustand zu versetzen.

Den Einzelschaltern 63, 64 des Kurzschlussschalters 13 sind Einschaltansteuerschaltungen 74a, 74b und Ausschaltansteuerschaltungen 73a, 73b zugeordnet. Die Einschaltansteuerschaltungen 74a, 74b sind dazu ausgelegt, die Einzelschalter 63, 64 zu schließen, während die Ausschaltansteuerschaltungen 73a, 73b dazu ausgelegt sind, die Einzelschalter 63, 64 zu öffnen.

Der Darstellung der Figur 4 ist zu entnehmen, dass die Einschaltansteuerschaltungen 71a, 71b sowie die Ausschaltansteueranordnungen 73a, 73b in einer Serienschaltung verschaltet sind. Diese Serienschaltung ist an eine Treiberspannung 24 sowie ein Massepotential 23 angeschlossen. Aktiviert werden kann die Serienschaltung durch einen ebenfalls in der Serienschaltung enthaltenen Treiberschalter 91. Wird der Treiberschalter 91 geschlossen, führt dies dazu, dass die Einzelschalter 61, 62 und somit die ersten und zweiten Schalter 11, 12 als Folge der Aktivierung der Einschaltansteuerschaltungen 71a, 71b eingeschaltet werden (und eingeschaltet bleiben). Dadurch wird die Pockelszelle 30 aufgeladen. Das Einschalten des Treiberschalters 91 führt weiterhin dazu, dass die Ausschaltansteuerschaltungen 73a, 73b aktiviert werden und die Einzelschalter 63, 64 geöffnet werden und geöffnet gehalten werden.

Eine weitere Serienschaltung umfasst die Treiberspannung 24, die Ausschaltansteuerschaltungen 72a, 72b sowie die Einschaltansteuerschaltungen 74a, 74b sowie den Treiberschalter 92, der an das Massepotential 23 angeschlossen ist. Wird der Treiberschalter 92 kurzzeitig eingeschaltet, führt dies dazu, dass die Ausschaltansteuerschaltungen 72a, 72b aktiv werden, was dazu führt, dass die Einzelschalter 61, 62 geöffnet werden und geöffnet bleiben und somit der erste Schalter 11 und der zweite Schalter 12 geöffnet werden. Gleichzeitig werden die Einschaltansteuerschaltungen 74a, 74b der Einzelschalter 63, 64 aktiviert, was dazu führt, dass die Einzelschalter 63, 64 geschlossen und somit der Kurzschlussschalter 13 geschlossen wird. Dadurch wird die Pockelszelle 30 entladen.

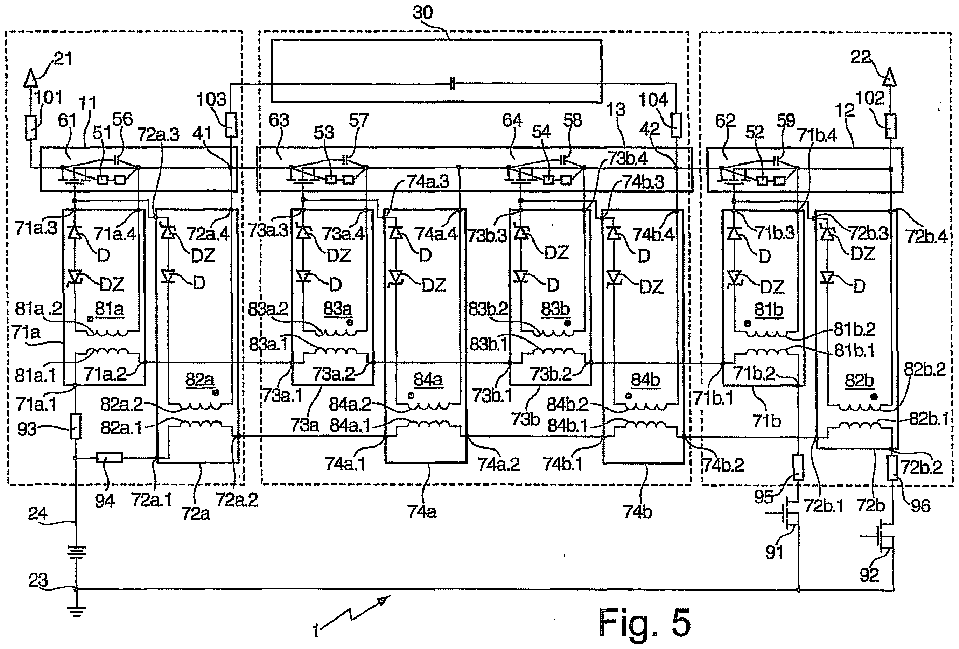

Die Figur 5 zeigt eine Pockelszellentreiberschaltung 1, an die eine Pockelszelle 30 angeschlossen ist. Insbesondere ist die Pockelszelle 30 über Widerstände 103, 104 an einen ersten Schaltungsknoten 41 und einen zweiten Schaltungsknoten 42 der Pockelszellentreiberschaltung 1 angeschlossen. Der erste Schaltungsknoten 41 ist über einen ersten Schalter 11 und einen Widerstand 101 mit einem positiven Potential 21, insbesondere +2000V, verbunden. Der zweite Schaltungsknoten 42 ist über einen zweiten Schalter 12 und einen Widerstand 102 an ein negatives Potential 22, insbesondere -2000V, angeschlossen. Die Schaltungsknoten 41, 42 sind über einen Kurzschlussschalter 13 miteinander verbunden. Der erste Schalter 11 weist eine Reihenschaltung von mehreren Einzelschaltern 61 auf, wobei in der Figur 5 lediglich ein Einzelschalter 61 dargestellt ist. Der zweite Schalter 12 weist ebenfalls eine Reihenschaltung mehrerer Einzelschalter 62 auf, wobei nur ein Einzelschalter 62 dargestellt ist.

Der Kurzschlussschalter 13 weist eine Reihenschaltung mehrerer Einzelschalter 63, 64 auf.

Den Einzelschaltern 61, 62 der ersten und zweiten Schalter 11, 12 ist jeweils eine Einschaltansteuerschaltung 71a, 71b zugeordnet, die dazu ausgelegt sind, die Einzelschalter 61, 62 in einen leitenden Zustand zu versetzen. Die Einschaltansteuerschaltungen 71a, 71b weisen jeweils einen Signalübertrager 81a, 81b auf. Die Primärseiten 81a.1, 81b.1 sind mit Eingangsanschlüssen 71a.1, 71a.2 und 71b.1, 71b.2 verbunden. Die Sekundärseiten bzw. Sekundärwicklungen 81a.2 und 81b.2 sind mit Ausgangsanschlüssen 71a.3, 71a.4, 71b.3, 71b.4 verbunden.

Weiterhin sind den Einzelschaltern 61, 62 Ausschaltansteuerschaltungen 72a, 72b zugeordnet, die jeweils einen Signalübertrager 82a, 82b aufweisen. Die Signalübertrager 82a, 82b weisen jeweils eine Primärseite 82a.1, 82b.1 sowie eine Sekundärseite 82a.2, 82b.2 auf. Die Primärseite 82a.1, 82b.1 bzw. Primärwicklung der Signalübertrager 82a, 82b ist mit Eingangsanschlüssen 72a.1, 72a.2 bzw. 72b.1, 72b. 2 verbunden. Entsprechend sind die Sekundärseiten bzw. Sekundärwicklungen 82a.2, 82b.2 mit Ausgangsanschlüssen 72a.3, 72a.4 bzw. 72b.3, 72b.4 verbunden.

Den Einzelschaltern 63, 64 des Kurzschlussschalters 13 sind Einschaltansteuerschaltungen 74a, 74b und Ausschaltansteuerschaltungen 73a, 73b zugeordnet. Die Einschaltansteuerschaltungen 74a, 74b weisen jeweils Signalübertrager 84a, 84b auf. Die Ausschaltansteuerschaltungen 73a, 73b weisen Signalübertrager 83a, 83b auf. Die Primärseiten bzw. Primärwicklungen 84a.1, 84b.1 sind mit Eingangsanschlüssen 74a.1, 74a.2 bzw. 74b.1, 74b.2 verbunden. Die Sekundärseiten bzw. Sekundärwicklungen 84a.2, 84a.2 sind mit Ausgangsanschlüssen 74a.3, 74a.4 bzw. 74b.3, 74b.4 verbunden.

Die Primärseiten bzw. Primärwicklungen 83a.1, 83b.2 sind mit Eingangsanschlüssen 73a.1, 73a.2 bzw. 73b.1, 73b.2 verbunden. Entsprechend sind die Sekundärseiten bzw. Sekundärwicklungen 83a.2, 83b.2 mit Ausgangsanschlüssen 73a.3, 73a.4 bzw. 73b.3, 73b.4 verbunden.

Die Eingangsanschlüsse 71a.1, 71a.2, 73a.1, 73a.2, 73b.1, 73b.2, 71b.1, 71b.2 sind in Serie miteinander verbunden. Dies bedeutet, dass die Eingangsanschlüsse 71a.1, 71a.2, 71b.1, 71b.2 der Einschaltansteuerschaltungen 71a, 71b der ersten und zweiten Schalter 11, 12 sowie die Eingangsanschlüsse 73a.1, 73a.2, 73b.1, 73b.2 der Ausschaltansteuerschaltungen 73a, 73b des Kurzschlussschalters 13 in Serie miteinander verbunden sind. In dieser Serienschaltung befindet sich weiterhin ein Treiberschalter 91, über den die Primärseiten 81a.1, 83a.1, 83b.1, 81b.1 der Signalübertrager 81a, 83a, 83b, 81b der Einschaltansteuerschaltungen 71a, 71b und der Ausschaltansteuerschaltungen 73a, 73b mit der Treiberspannung 24 verbunden werden können. Die Treiberspannung kann etwa 350V betragen, insbesondere kann sie im Bereich 100 bis 500V liegen. In dieser Serienschaltung befinden sich weiterhin ein Widerstand 93 und ein Widerstand 95. Diese Widerstände dienen der Dämpfung von Schwingungen, die beim Schaltvorgang auftreten können.

Weiterhin sind die Eingangsanschlüsse 72a.1, 72a.2, 74a.1, 74a.2, 74b.1, 74b.2, 72b.1, 72b.2 in einer Serienschaltung miteinander verbunden. Diese Serienschaltung weist ebenfalls einen Treiberschalter 92 auf, über den die zweite Serienschaltung mit der Treiberspannung 24 verbunden werden kann. In dieser Serienschaltung befinden sich weiterhin ein Widerstand 94 und ein Widerstand 96. Diese Widerstände dienen ebenfalls der Dämpfung von Schwingungen, die beim Schaltvorgang auftreten können. Mit 23 ist ein Mittenpotential angegeben.

Die Ausgangsanschlüsse 71a.3, 72a.3 sind mit einem Ansteueranschluss des Einzelschalters 61 verbunden. Die Ausgangsanschlüsse 71a.4, 72a.4 sind mit einem Leistungsanschluss des Einzelschalters 61 verbunden. Die Ausgangsanschlüsse 73a.3, 74a.3 sind mit dem Ansteueranschluss des Einzelschalters 63 und die Ausgangsanschlüsse 73b.3, 74b.3 sind mit dem Ansteueranschluss des Einzelschalters 64 verbunden. Die Ausgangsanschlüsse 73a.4, 74a.4 sind mit einem Leistungsanschluss des Einzelschalters 63 und die Ausgangsanschlüsse 73b.4, 74b.4 mit einem Leistungsanschluss des Einzelschalters 64 verbunden.

Die Ausgangsanschlüsse 71b.3, 72b.3 sind mit dem Ansteueranschluss des Einzelschalters 62 verbunden. Die Ausgangsanschlüsse 71b.4, 72b.4 sind mit einem Leistungsanschluss des Einzelschalters 62 verbunden.

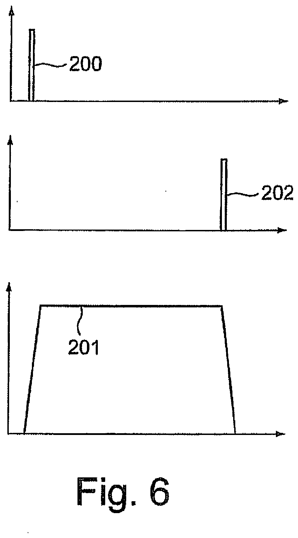

Wird nun der Treiberschalter 91 eingeschaltet, was in der Figur 6 bei der Bezugsziffer 200 dargestellt ist, führt dies dazu, dass die Einzelschalter 61, 62 und somit die ersten und zweiten Schalter 11, 12 als Folge der Aktivierung der Einschaltansteuerschaltungen 71a, 71b eingeschaltet werden (und eingeschaltet bleiben). Dadurch wird die Pockelszelle 30 aufgeladen, d.h. über der Pockelszelle 30 liegt eine Spannung von etwa im Ausführungsbeispiel 4000V an, was in der Figur 6 mit der Bezugsziffer 201 dargestellt ist. Das Einschalten des Treiberschalters 91 hat dazu geführt, dass die Ausschaltansteuerschaltungen 73a, 73b aktiviert wurden und die Einzelschalter 63, 64 geöffnet wurden und geöffnet gehalten werden.

Wird nun der Treiberschalter 92 kurzzeitig eingeschaltet, wie dies bei der Bezugsziffer 202 der Figur 6 gezeigt ist, führt dies dazu, dass die Ausschaltansteuerschaltungen 72a, 72b aktiv werden, was dazu führt, dass die Einzelschalter 61, 62 geöffnet werden (und geöffnet bleiben) und somit der erste Schalter 11 und der zweite Schalter 12 geöffnet werden. Gleichzeitig werden die Einschaltansteuerschaltungen 74a, 74b der Einzelschalter 63, 64 aktiviert, was dazu führt, dass die Einzelschalter 63, 64 geschlossen und somit der Kurzschlussschalter 13 geschlossen wird. Dadurch wird die Pockelszelle 30 entladen.

In der Schaltung gemäß Figur 5 ist zu erkennen, dass Widerstände 51 über die Leistungsanschlüsse des Einzelschalters 61, Widerstände 53 über die Leistungsanschlüsse des Einzelschalters 63, Widerstände 54 über die Leistungsanschlüsse des Einzelschalters 64 und Widerstände 52 über die Leistungsanschlüsse des Einzelschalters 62 geschaltet sind. Diese Widerstände ebenso wie die dazu parallel geschalteten Kondensatoren 56, 57, 58, 59 dienen der Symmetrierung. Insbesondere bei nicht leitend geschalteten Einzelschaltern 61, 62, 63, 64 soll so sichergestellt werden, dass der Spannungsabfall an den einzelnen Einzelschaltern 61, 62, 63, 64 sich möglichst gleichmäßig auf die Einzelschalter 61, 62, 63, 64 verteilt und nicht ein Einzelschalter 61, 62, 63 64 die ganze Spannung sperren muss. Den gleichen Zweck haben auch die Kondensatoren 56, 57, 58, 59.

Die ebenfalls in der Figur 5 dargestellten Widerstände 93, 94, 95, 96 dienen zur Dämpfung von möglichen Schwingungen. Solche Schwingungen können auftreten, wenn Schalter sehr schnell geschaltet werden. Die Schwingungen können einzelne Einzelschalter 61, 62, 63, 64 im Ausschaltvorgang wieder einschalten, was unerwünscht wäre, weil dann die Spannung des positiven bzw. negativen Potenzials die verbleibenden ausgeschalteten Einzelschalter 61, 62, 63 64 über ihre Durchbruchspannungen belasten könnte. Die Widerstände 93, 94 sind in der Nähe der Treiberspannung 24 insbesondere für beide Serienschaltungen symmetrisch angeordnet. Ebenso sind die Widerstände 95, 96 sind in der Nähe des Mittenpotentials 23 bzw. in der Nähe der Treiberschalter 91, 92 insbesondere für beide Serienschaltungen symmetrisch angeordnet.

Die Widerstände 101, 102, 103, 104 haben eine ähnliche Wirkung, d.h. dienen zur Dämpfung von Schwingungen.

Zwischen den Ausgangsanschlüssen 71a.3, 72a.3, 73a.3, 74a.3, 73b.3, 74b.3, 71b.3 und 72b.3 und der Sekundärseite der Signalübertrager 81a, 82a, 83a, 84a, 81b, 82b, 83b, 84b sind Dioden geschaltet. Genauer gesagt ist den Ausgangsanschlüssen 71a.3, 72a.3, 73a.3, 74a.3, 73b.3, 74b.3, 71b.3 und 72b.3 jeweils eine Reihenschaltung aus einer Diode D und einer Zehnerdiode DZ vorgeschaltet. Die Dioden D und Zehnerdioden DZ sind jeweils gegensinnig miteinander verbunden. Dadurch können die Schalter 11, 12, 13 schnell und sicher ein- und ausgeschaltet werden.

Die Polarität der Signalübertrager 81a, 82a, 83a, 84a, 83b, 84b, 81b, 82b und die Stromrichtung der Dioden D, DZ ist beim Kurzschlussschalter 13 umgekehrt zu den ersten und zweiten Schaltern 11, 12. Dadurch wird sichergestellt, dass die ersten und zweiten Schalter 11, 12 und der Kurzschlussschalter 13 gegensinnig geschaltet werden.

Aus den Fig. 1 bis 5 und der Beschreibung dazu wird klar, dass der Kurzschlussschalter 13 in seiner Gesamtheit ausschließlich zur Reduzierung (und nicht zur Erhöhung) eines zwischen dem ersten Schaltungsknoten 41 und dem zweiten Schaltungsknoten 42 anliegenden Potentials ausgelegt und geeignet angeordnet ist. Insbesondere sind auch nicht Teile von ihm zu Erhöhung dieses Potentials geeignet angeordnet.

Aus den Fig. 1 bis 5 und der Beschreibung dazu wird zudem klar, dass jeder einzelne Einzelschalter 63, 64 des Kurzschlussschalters 13 ausschließlich zur Reduzierung eines zwischen dem ersten Schaltungsknoten 41 und dem zweiten Schaltungsknoten 42 anliegenden Potentials geeignet angeordnet ist. Insbesondere ist kein einzelner von ihnen zur Erhöhung dieses Potentials geeignet angeordnet.

Aus den Fig. 1 bis 5 und der Beschreibung dazu wird zudem klar, dass der erste Schalter 11 und jeder einzelne Einzelschalter 61 des ersten Schalters 11 ausschließlich zur Verbindung des ersten Schaltungsknotens 41 mit dem ersten positiven Potential 21 geeignet angeordnet ist. Insbesondere ist kein einzelner der Schalter 11, 61 zur Reduzierung eines zwischen dem ersten und dem zweiten Schaltungsknoten 41,42 anliegenden Potentials geeignet angeordnet. Aus den Fig. 1 bis 5 und der Beschreibung dazu wird zudem klar, dass der zweite Schalter 12 und jeder einzelne Einzelschalter 62 des zweiten Schalters 12 ausschließlich zur Verbindung des zweiten Schaltungsknotens 42 mit dem zweiten negativen Potential 22 geeignet angeordnet ist. Insbesondere ist kein einzelner der Schalter 12, 62 zur Reduzierung eines zwischen dem ersten und dem zweiten Schaltungsknoten 41,42 anliegenden Potentials geeignet angeordnet.

Aus den Fig. 3 bis 5 und der Beschreibung dazu wird zudem klar, dass die Pockelszellentreiberschaltung 1 dazu ausgelegt ist, alle Einzelschalter 63, 64 des Kurzschlussschalters 13 durch Einschalten eines Treiberschalters 92 gleichzeitig zu schließen, und/oder alle Einzelschalter 63, 64 des Kurzschlussschalters 13 durch Einschalten eines Treiberschalters 91 gleichzeitig zu öffnen.

Aus den Fig. 3 bis 5 und der Beschreibung dazu wird zudem klar, dass die Einschaltansteuerschaltungen 74a, 74b dazu ausgelegt sind, alle Einzelschalter 63, 64 des Kurzschlussschalters 13 gleichzeitig zu schließen, und/oder die Ausschaltansteuerschaltungen 73a, 73b dazu ausgelegt sind, alle Einzelschalter 63, 64 des Kurzschlussschalters 13 gleichzeitig zu öffnen.

Aus den Fig. 3 bis 5 und der Beschreibung dazu wird zudem klar, dass mehrere insbesondere alle Einzelschalter 63, 64 des Kurzschlussschalters 13 gleichzeitig ein- bzw. ausgeschaltet werden. Außerdem wird klar, dass alle Einzelschalter 61 des ersten Schalters 11 und alle Einzelschalter 62 des zweiten Schalters 12 gleichzeitig ein- bzw. ausgeschaltet werden.

## Patentansprüche

1. Pockelszellentreiberschaltung (1) mit einem ersten Schaltungsknoten (41), der mit einem ersten Anschluss einer Pockelszelle (30) verbindbar ist, und einem zweiten Schaltungsknoten (42), der mit einem zweiten Anschluss einer Pockelszelle (30) verbindbar ist, wobei der erste Schaltungsknoten (41) über einen ersten Schalter (11) mit einem positiven Potential (21) verbunden ist und ein zweiter Schalter (12) an den zweiten Schaltungsknoten (42) angeschlossen ist, wobei der zweite Schaltungsknoten (42) über den zweiten Schalter (12) mit einem negativen Potential (22) verbunden ist und der erste Schaltungsknoten (41) mit dem zweiten Schaltungsknoten (42) über einen zur Entladung einer angeschlossenen Pockelszelle (30) angesteuerten Kurzschlussschalter (13) verbunden ist, wobei der Kurzschlussschalter (13) und der erste und der zweite Schalter (11, 12) je eine Reihenschaltung mehrerer Einzelschalter (61, 62, 63, 64) umfassen, wobei jeder Einzelschalter (61, 62, 63, 64) eine Einschaltansteuerschaltung (71a, 71b, 74a, 74b) und/oder eine Ausschaltansteuerschaltung (72a, 72b, 73a, 73b) aufweist, **dadurch gekennzeichnet, dass** die Einschaltansteuerschaltungen (71a, 71b) des ersten und des zweiten Schalters (11, 12) und die Ausschaltansteuerschaltung (73a, 73b) des Kurzschlussschalters (13) an ihren Eingangsanschlüssen (71a.1, 71a.2, 73a.1, 73a.2, 73b.1, 73b.2, 71b.1, 71b.2) in einer ersten Serienschaltung und/oder die Ausschaltansteuerschaltungen (72a, 72b) des ersten und des zweiten Schalters (11, 12) und die Einschaltansteuerschaltung (74a, 74b) des Kurzschlussschalters (13) an ihren Eingangsanschlüssen (72a.1, 72a.2, 74a.1, 74a.2, 74b.1, 74b.2, 72b.1, 72b.2) in einer zweiten Serienschaltung geschaltet sind.

2. Pockelszellentreiberschaltung nach Anspruch 1, wobei der Kurzschlussschalter (13) ausgelegt ist, eine Spannung zwischen den Schaltungsknoten (41, 42) von > 1000V, insbesondere > 2kV, vorzugsweise > 4kV auf < 100V in einer Zeitspanne < 200ns, insbesondere <100ns, vorzugsweise < 50ns, besonders bevorzugt <10ns zu reduzieren.

3. Pockelszellentreiberschaltung nach einem der vorhergehenden Ansprüche, wobei der Kurzschlussschalter (13) ausgelegt ist, eine Pockelszelle mit einer Kapazität zwischen 1pF und 20pF, die auf eine Spannung > 1000V, insbesondere > 2kV, vorzugsweise > 4kV, besonders vorzugsweise auch >8kV in einer Zeitspanne < 200ns, insbesondere <100ns, vorzugsweise < 50ns, besonders bevorzugt <10ns auf Spannung < 100V zu entladen.

4. Pockelszellentreiberschaltung nach einem der vorhergehenden Ansprüche, wobei der Kurzschlussschalter (13) ausgelegt ist, beim Einschalten eine Ladung >100nC, insbesondere >200nC, vorzugsweise >400nC innerhalb einer Zeitspanne < 100ns, insbesondere <10ns aus der Pockelszelle (30) zu entladen.

5. Pockelszellentreiberschaltung nach einem der vorhergehenden Ansprüche, wobei Einschaltansteuerschaltungen (74a, 74b) vorgesehen und dazu ausgelegt sind, alle Einzelschalter (63, 64) des Kurzschlussschalters (13) gleichzeitig zu schließen, und/oder Ausschaltansteuerschaltungen (73a, 73b) vorgesehen und dazu ausgelegt sind, alle Einzelschalter (63, 64) des Kurzschlussschalters (13) gleichzeitig zu öffnen.

6. Pockelszellentreiberschaltung nach einem der vorhergehenden Ansprüche, wobei die Reihenschaltung der Einzelschalter des Kurzschlussschalters mit der Reihenschaltung der Einzelschalter des ersten und des zweiten Schalters eine Reihenschaltung aller Einzelschalter bildet.

7. Pockelszellentreiberschaltung nach Anspruch 6, wobei in der Reihenschaltung aller Einzelschalter ein Widerstand insbesondere mehrere Widerstände angeordnet sind.

8. Pockelszellentreiberschaltung nach Anspruch 7, wobei je ein Widerstand zwischen dem ersten Schaltungsknoten und dem positiven Potential und zwischen dem zweiten Schaltungsknoten und dem negativen Potential angeordnet ist.

9. Pockelszellentreiberschaltung nach Anspruch 8, wobei die Widerstände Werte zwischen 1 und 200 Ohm aufweisen.

10. Pockelszellentreiberschaltung nach einem der vorhergehenden Ansprüche, wobei die Einschaltansteuerschaltung (71a, 71b, 74a, 74b) ausgelegt ist, den Einzelschalter (61, 62, 63, 64) in einen leitenden Zustand zu versetzen, und die Ausschaltansteuerschaltung (72a, 72b, 73a, 73b) ausgelegt ist, den Einzelschalter (61, 62, 63, 64) in einen nicht leitenden Zustand zu versetzen.

11. Pockelszellentreiberschaltung nach einem der vorhergehenden Ansprüche, wobei die Einschaltansteuerschaltung (71a, 71b, 74a, 74b) bzw. die Ausschaltansteuerschaltung (72a, 72b, 73a, 73b) je einen, insbesondere je einen baugleichen Signalübertrager (81a-84b) aufweist.

12. Pockelszellentreiberschaltung nach einem der vorhergehenden Ansprüche, wobei die Serienschaltung der Ausschaltansteuerschaltungen (72a, 72b) des ersten und des zweiten Schalters (11, 12) und die Einschaltansteuerschaltungen (74a, 74b) des Kurzschlussschalters (13) über einen ersten Treiberschalter (92) an eine Treiberspannung (24) anschließbar ist und/oder wobei die Serienschaltung der Einschaltansteuerschaltungen (71a, 71b) des ersten und des zweiten Schalters (11, 12) und die Ausschaltansteuerschaltungen (73a, 73b) des Kurzschlussschalters (13) über einen zweiten Treiberschalter (91) an die Treiberspannung (24) anschließbar sind.

13. Pockelszellentreiberschaltung nach einem der vorhergehenden Ansprüche, wobei die Schaltungsknoten (41, 42) bei geschlossenem ersten und zweiten Schalter (11, 12) betragsmäßig auf demselben Potential liegen.

14. Pockelszellentreiberschaltung nach einem der vorhergehenden Ansprüche, wobei Widerstände (51, 54), insbesondere Symmetrierwiderstände, und/oder kapazitive Elemente (56,57, 58, 59), insbesondere Kondensatoren, zwischen den Leistungsanschlüssen eines Einzelschalters (61, 62, 63, 64) vorgesehen sind.

15. Pockelszellentreiberschaltung nach einem der vorhergehenden Ansprüche, wobei Widerstände (93-96) in der ersten und insbesondere auch in der zweiten Serienschaltung vorgesehen sind, insbesondere baugleiche Widerstände mit gleichgroßen Werten, insbesondere im Bereich von jeweils 1 Ohm bis 50 Ohm insbesondere 10 Ohm bis 50 Ohm.

## Claims

1. A Pockels cell driver circuit (1) with a first circuit node (41) that can be connected to a first terminal of a Pockels cell (30), and a second circuit node (42) that can be connected to a second terminal of a Pockels cell (30), wherein the first circuit node (41) is connected via a first switch (11) to a positive potential (21) and a second switch (12) is connected to the second circuit node (42), wherein the second circuit node (42) is connected via the second switch (12) to a negative potential (22) and the first circuit node (41) is connected to the second circuit node (42) via a short-circuit switch (13) which is activated for discharge of a linked Pockels cell (30), wherein the short-circuit switch (13) and the first and second switch (11, 12) each comprise a serial connection of multiple individual switches (61, 62, 63, 64), wherein each individual switch (61, 62, 63, 64) has a turn-on driver circuit (71a, 71b, 74a, 74b) and/or a turn-off driver circuit (72a, 72b, 73a, 73b), **characterized in that** the turn-on driver circuits (71a, 71b) of the first and second switches (11, 12) and the turn-off driver circuit (73a, 73b) of the short-circuit switch (13) are connected in a first serial connection at their input terminals (71a.1, 71a.2, 73a.1, 73a.2, 73b.1, 73b.2, 71b.1, 71b.2) and/or the turn-off driver circuits (72a, 72b) of the first and second switch (11, 12) and the turn-on driver circuit (74a, 74b) of the short-circuit switch (13) are connected in a second serial connection at their input terminals (72a.1, 72a.2, 74a.1, 74a.2, 74b.1, 74b.2, 72b.1, 72b.2).

2. A Pockels cell driver circuit in accordance with claim 1, wherein the short-circuit switch (13) is configured so as to reduce a voltage between the circuit nodes (41, 42) from >1000 V, in particular > 2 kV, preferably > 4 kV, to < 100 V in a timespan of < 200 ns, in particular < 100 ns, preferably < 50ns, especially preferably < 10ns.

3. A Pockels cell driver circuit in accordance with one of the preceding claims, wherein the short-circuit switch (13) is configured to discharge a Pockels cell of a capacitance of between 1pF and 20pF with a voltage > 1000V, in particular > 2kV, preferably > 4kV, with particular preference also > 8kV to a voltage of < 100 V within a timespan < 200ns, in particular < 100 ns, preferably < 50 ns, with particular preference < 10 ns.

4. A Pockels cell driver circuit in accordance with one of the preceding claims, wherein the short-circuit switch (13) is configured so as to discharge an electrical charge of > 100 nC, in particular > 200nC, preferably >400n C, within a timespan of < 100 ns, in particular < 10ns, from the Pockels cell (30) when it is switched on.

5. A Pockels cell driver circuit in accordance with one of the preceding claims, wherein turn-on driver circuits (74a, 74b) are provided and are configured to close all the individual switches (63, 64) of the short-circuit switch (13) simultaneously, and/or turn-off driver circuits (73a, 73b) are provided, and configured to open all the individual switches (63, 64) of the short-circuit switch (13) simultaneously.

6. Pockels cell driver circuit in accordance with one of the preceding claims, wherein the serial connection of the individual switches of the short-circuit switch forms a serial connection of all the individual switches with the serial connection of the individual switches of the first and second switch.

7. A Pockels cell driver circuit in accordance with claim 6, wherein in the serial connection of all the individual switches a resistor, in particular multiple resistors, is arranged.

8. Pockels cell driver circuit in accordance with claim 7, wherein a resistor is arranged between the first circuit node and the positive potential and between the second circuit node and the negative potential respectively.

9. A Pockels cell driver circuit in accordance with claim 8, wherein the resistors have values of between 1 and 200 ohms.

10. A Pockels cell driver circuit in accordance with one of the preceding claims, wherein the turn-on driver circuit (71a, 71b, 74a, 74b) is configured in such a way as to transfer the individual switch (61, 62, 63, 64) into a conductive state, and the turn-off driver circuit (72a, 72b, 73a, 73b) is configured in such a way as to transfer the individual switch (61, 62, 63, 64) into a non-conductive state.

11. A Pockels cell driver circuit in accordance with one of the preceding claims, wherein the turn-on driver circuit (71a, 71b, 74a, 74b) or the turn-off driver circuit (72a, 72b, 73a, 73b) each has a signal transformer (81a-84b), in particular one of identical construction.

12. A Pockels cell driver circuit in accordance with one of the preceding claims, wherein the serial connection of the turn-off driver circuits (72a, 72b) of the first and second switches (11, 12) and the turn-on driver circuits (74a, 74b) of the short-circuit switch (13) can be connected to a driver voltage (24) via a first driver switch (92) and/or wherein the serial connection of the turn-on driver circuits (71a, 71b) of the first and second switches (11, 12) and the turn-off driver circuits (73a, 73b) of the short-circuit switch (13) can be connected to the driver voltage (24) via a second driver switch (91).

13. A Pockels cell driver circuit in accordance with one of the preceding claims, wherein the circuit nodes (41, 42) are on a common potential of the same absolute value when the first and second switches (11, 12) are closed.

14. A Pockels cell driver circuit in accordance with one of the preceding claims, wherein resistors (51, 54), in particular balancing resistors and/or capacitive elements (56, 57, 58, 59), in particular capacitors, are provided between the power terminals of an individual switch (61, 62, 63, 64).

15. A Pockels cell driver circuit in accordance with one of the preceding claims, wherein resistors (93-96) are provided in the first and in particular also the second serial connection, in particular resistors of identical construction with the same values, especially in the range of 1 ohm to 50 ohms respectively, in particular 10 ohms to 50 ohms.

## Revendications

1. Circuit d'attaque de cellule de Pockels (1) comportant un premier noeud de circuit (41) qui peut être relié à une première borne d'une cellule de Pockels (30) et un second noeud de circuit (42) qui peut être relié à une seconde borne d'une cellule de Pockels (30), le premier noeud de circuit (41) étant relié à un potentiel positif (21) via un premier commutateur (11) et un second commutateur (12) étant relié au second noeud de circuit (42), le second noeud de circuit (42) étant relié à un potentiel négatif (22) via le second commutateur (12) et le premier noeud de circuit (41) étant relié au second noeud de circuit (42) via un commutateur de court-circuit (13) qui est commandé pour décharger une cellule de Pockels (30) connectée, le commutateur de court-circuit (13) et les premier et second commutateurs (11, 12) comprenant chacun un circuit série de plusieurs commutateurs individuels (61, 62, 63, 64), chaque commutateur individuel (61, 62, 63, 64) présentant un circuit de commande de mise sous tension (71a, 71b, 74a, 74b) et/ou un circuit de commande de mise hors tension (72a, 72b, 73a, 73b), **caractérisé en ce que** les circuits de commande de mise sous tension (71a, 71b) des premier et second commutateurs (11, 12) et le circuit de commande de mise hors tension (73a, 73b) du commutateur de court-circuit (13) sont couplés à leurs bornes d'entrée (71a.1, 71a.2, 73a.1, 73a.2, 73b.1, 73b.2, 71b.1, 71b.2) en un premier circuit série et/ou les circuits de commande de mise hors tension (72a, 72b) des premier et second commutateurs (11, 12) et le circuit de commande de mise sous tension (74a, 74b) du commutateur de court-circuit (13) sont couplés à leurs bornes d'entrée (72a.1, 72a.2, 74a.1, 74a.2, 74b.1, 74b.2, 72b.1, 72b.2) en un second circuit série.

2. Circuit d'attaque de cellule de Pockels selon la revendication 1, dans lequel le commutateur de court-circuit (13) est conçu pour réduire une tension entre les noeuds de circuit (41, 42) de > 1000 V, en particulier > 2 kV, de préférence > 4 kV, à < 100 V dans un intervalle de temps < 200 ns, en particulier < 100 ns, de préférence < 50 ns, particulièrement de préférence < 10 ns.

3. Circuit d'attaque de cellule de Pockels selon l'une des revendications précédentes, dans lequel le commutateur de court-circuit (13) est conçu pour décharger une cellule de Pockels avec une capacité comprise entre 1 pF et 20 pF qui est à une tension > 1000 V, en particulier > 2 kV, de préférence > 4 kV, particulièrement de préférence aussi > 8 kV à une tension < 100 V dans un intervalle de temps < 200 ns, en particulier < 100 ns, de préférence < 50 ns, particulièrement de préférence < 10 ns.

4. Circuit d'attaque de cellule de Pockels selon l'une des revendications précédentes, dans lequel le commutateur de court-circuit (13) est conçu pour décharger à la mise sous tension une charge > 100 nC, en particulier > 200 nC, de préférence >400nC de la cellule de Pockels (30) dans un intervalle de temps < 100 ns, en particulier < 10 ns.

5. Circuit d'attaque de cellule de Pockels selon l'une des revendications précédentes, dans lequel les circuits de commande de mise sous tension (74a, 74b) sont prévus et conçus pour fermer simultanément tous les commutateurs individuels (63, 64) du commutateur de court-circuit (13) et/ou les circuits de commande de mise hors tension (73a, 73b) sont prévus et conçus pour ouvrir simultanément tous les commutateurs individuels (63, 64) du commutateur de court-circuit (13).

6. Circuit d'attaque de cellule de Pockels selon l'une des revendications précédentes, dans lequel le circuit série des commutateurs individuels du commutateur de court-circuit forme avec le circuit série des commutateurs individuels des premier et second commutateurs un circuit série de tous les commutateurs individuels.

7. Circuit d'attaque de cellule de Pockels selon la revendication 6, dans lequel une résistance, en particulier plusieurs résistances, sont disposées dans le circuit série de tous les commutateurs individuels.

8. Circuit d'attaque de cellule de Pockels selon la revendication 7, dans lequel une résistance est chaque fois disposée entre le premier noeud de circuit et le potentiel positif et entre le second noeud de circuit et le potentiel négatif.

9. Circuit d'attaque de cellule de Pockels selon la revendication 8, dans lequel les résistances présentent des valeurs comprises entre 1 et 200 ohms.

10. Circuit d'attaque de cellule de Pockels selon l'une des revendications précédentes, dans lequel le circuit de commande de mise sous tension (71a, 71b, 74a, 74b) est conçu pour mettre le commutateur individuel (61, 62, 63, 64) dans un état conducteur et le circuit de commande de mise hors tension (72a, 72b, 73a, 73b) est conçu pour mettre le commutateur individuel (61, 62, 63, 64) dans un état non conducteur.

11. Circuit d'attaque de cellule de Pockels selon l'une des revendications précédentes, dans lequel le circuit de commande de mise sous tension (71a, 71b, 74a, 74b) et le circuit de commande de mise hors tension (72a, 72b, 73a, 73b) présentent en particulier chacun un transmetteur de signaux (81a-84b) de construction identique.

12. Circuit d'attaque de cellule de Pockels selon l'une des revendications précédentes, dans lequel le circuit série des circuits de commande de mise hors tension (72a, 72b) des premier et second commutateurs (11, 12) et les circuits de commande de mise sous tension (74a, 74b) du commutateur de court-circuit (13) peuvent être connectés à une tension d'attaque (24) par l'intermédiaire d'un premier commutateur d'attaque (92) et/ou dans lequel le circuit série des circuits de commande de mise sous tension (71a, 71b) des premier et second commutateurs (11, 12) et les circuits de commande de mise hors tension (73a, 73b) du commutateur de court-circuit (13) peuvent être connectés à la tension d'attaque (24) par l'intermédiaire d'un second commutateur d'attaque (91).

13. Circuit d'attaque de cellule de Pockels selon l'une des revendications précédentes, dans lequel les noeuds de circuit (41, 42) sont au même potentiel en valeur absolue lorsque les premier et second commutateurs (11, 12) sont fermés.

14. Circuit d'attaque de cellule de Pockels selon l'une des revendications précédentes, dans lequel des résistances (51, 54), en particulier des résistances d'équilibrage, et/ou des éléments capacitifs (56, 57, 58, 59), en particulier des condensateurs, sont prévus entre les bornes de puissance d'un commutateur individuel (61, 62, 63, 64).

15. Circuit d'attaque de cellule de Pockels selon l'une des revendications précédentes, dans lequel des résistances (93-96) sont prévues dans le premier et en particulier aussi dans le second circuit série, en particulier des résistances de construction identique ayant des valeurs identiques, en particulier dans la plage de 1 ohm à 50 ohms, en particulier de 10 ohms à 50 ohms.
